Europäisches Patentamt

European Patent Office

Office européen des brevets

(19)

(11) Veröffentlichungsnummer: **0 047 827**

**A1**

(12)
# EUROPÄISCHE PATENTANMELDUNG

(21) Anmeldenummer: **81105369.3**

(22) Anmeldetag: **10.07.81**

(51) Int. Cl.³: **H 01 R 23/72**

(30) Priorität: **28.08.80 DE 3032353**

(43) Veröffentlichungstag der Anmeldung:
**24.03.82 Patentblatt 82/12**

(84) Benannte Vertragsstaaten:
**AT BE CH DE FR GB IT LI NL SE**

(71) Anmelder: **Rafi GmbH & Co Elektrotechnische
Spezialfabrik
Ravensburger Strasse 128-134
D-7981 Berg bei Ravenburg(DE)**

(72) Erfinder: **Wasmeier, Albert
Schenk-Konrad-Weg 60
D-7981 Blitzenreute(DE)**

(74) Vertreter: **Engelhardt, Guido
Ehlersstrasse 17
D-7990 Friedrichshafen1(DE)**

(54) Vorrichtung zur Halterung von Bauelementen auf einer Leiterplatte.

(57) Bei einer Vorrichtung (1) zur Halterung elektrischer Bauelemente (2), wie Taster, Schalter oder dgl., auf einer Leiterplatte (3) ist dieses mit einer mit Kontaktstiften (13) ausgestatteten Bodenplatte (12; 22) versehen, die über das Bauelement (2) oder unmittelbar mit der Leiterplatte (3) verspannbar ist. Dazu ist die Bodenplatte entgegen der Kraft einer oder mehrerer Federn (15) verschiebbar in dem Gehäuse (11) des Bauelementes (2) gehalten und zusammen mit dem Gehäuse (11) des Bauelementes (2) an der Leiterplatte (3) abgestützt. Zur unmittelbaren Verspannung der Leiterplatte (3) mit einer Bodenplatte (22) kann diese auch einen die Leiterplatte (3) durchgreifenden Ansatz (24) aufweisen, zwischen dem und der Leiterplatte (3) eine Druckfeder (25) abgestützt ist.

Diese Ausgestaltung ermöglicht es, eine lötlose Kontaktierung vorzunehmen, da die Kontaktstifte gegen die auf der Leiterplatte aufkaschierten Leiterbahnen gedrückt werden. Damit entfallen sowohl die in eine Leiterplatte einzuarbeitenden Bohrungen für die Kontakte als auch sämtliche mit einer Lötung verbundenen zusätzlichen Arbeiten. Das Bauelement ist vielmehr lediglich auf eine Leiterplatte aufzurasten, um eine zuverlässige langlebige elektrische Verbindung herzustellen.

FIG. 1

Rafi GmbH & Co
Elektrotechnische Spezialfabrik
7981 Berg b. Ravensburg

Vorrichtung zur Halterung von Bauelementen
auf einer Leiterplatte

Die Erfindung bezieht sich auf eine Vorrichtung zur Halterung
elektrischer Bauelemente, wie Taster, Schalter oder dgl., auf
einer Leiterplatte, die miteinander elektrisch leitend verbunden sind.

Elektrische Bauelemente werden bisher mit einer Leiterplatte
in der Weise verbunden, daß deren Kontakte durch diese hindurchgeführt und auf der Rückseite der Leiterplatte angelötet
werden. Abgesehen davon, daß Lötungen stets störanfällig
sind, bedingt dies nicht nur, daß in die Leiterplatte eine
Vielzahl von Löchern eingearbeitet werden müssen, sondern
die Lötungen selbst erfordern auch einen großen Arbeits- und
Zeitaufwand. Die Leiterplatte mit bereits aufgesetzten Bauelementen, die unter Umständen noch zusätzlich mechanisch
mit dieser zu verbinden sind, ist nämlich, damit sich einwandfreie Lötverbindungen ergeben, in einem Flußmittelbad
zu behandeln. Die dabei auftretenden Flußmitteldämpfe können
sich jedoch auf den Kontakten niederschlagen, so daß diese
mitunter ausfallen. Auch ist das Flußmittel, das zwischen
die Leiterplatte unter  den Bauelementen gelangt, oftmals
nach der Lötung nicht mehr abwaschbar. Wird aber ein aggressivesFlußmittel verwendet, führt dies zu Zerstörungen. Bei
nicht aggressiven Flußmitteln ergeben sich meist schlechte

./.

Lötverbindungen, die wiederum von Hand nachgelötet werden müssen. Eine elektrisch leitende Verbindung zwischen einer Leiterplatte und den auf dieser angeordneten Bauelementen ist daher in der bisher bekannten Weise nur mit einem verhältnismäßig großem Aufwand zu bewerkstelligen und damit teuer.

Es ist daher Aufgabe der Erfindung, eine Vorrichtung zur Halterung elektrischer Bauelemente auf einer Leiterplatte zu schaffen, durch die diese, ohne daß Lötverbindungen und der damit verbundene Aufwand erforderlich sind, miteinander elektrisch zuverlässig verbunden werden. Auch sollen die in die Leiterplatte einzuarbeitenden Bohrungen zur Aufnahme der Kontakte der Bauelemente entfallen, so daß die Bestückung einer Leiterplatte mit elektrischen Bauelementen mit äußerst geringem Arbeitsaufwand und in sehr kurzer Zeit vorzunehmen ist, dennoch soll eine dauerhafte Kontaktierung gegeben sein.

Gemäß der Erfindung wird dies erreicht, daß das Bauelement jeweils eine mit einem oder mehreren Kontaktstiften versehene Bodenplatte aufweist, die über das Bauelement oder unmittelbar mit der Leiterplatte verspannbar ist.

Zur Verspannung der Bodenplatte ist es angebracht, diese entgegen der Kraft einer oder mehrerer Federn verschiebbar in dem Gehäuse des Bauelementes zu halten und die Bodenplatte sowie das Gehäuse des Bauelementes an der Leiterplatte abzustützen.

Die auf die Bodenplatte einwirkende Feder sollte sich hierbei an einer Zwischenwand des Gehäuses abstützen. Zur Abstützung des Gehäuses an der Leiterplatte solltendagegen an diesem mit Hinterschneidungen versehene Rastansätze angeformt sein, die Ausnehmungen der Leiterplatte durchgreifen.

./.

Zur unmittelbaren Verspannung der Leiterplatte mit einer
Bodenplatte kann nach einer andersartigen Ausführungsform
diese einen die Leiterplatte durchgreifenden Ansatz aufweisen, zwischen dem und der Leiterplatte eine Druckfeder
abgestützt ist.

Zur Einstellung der Verspannkraft ist es zweckmässig, den
Ansatz mit einem verstellbaren, beispielsweise durch eine
auf diesen aufschraubbare Mutter gebildeten Anschlag zu
versehen.

Vorteilhaft ist es des weiteren, um eine ungleichmässige Anlage der Kontaktstifte auszuschließen, die Bodenplatte jeweils über eine aus Auflagenocken und/oder Kontaktstiften gebildete Dreipunkt-Abstützung auf der Leiterplatte zu halten.
Zu dem gleichen Zweck können die Kontaktstifte aber auch in
Achsrichtung federnd gehalten werden.

Außerdem sollte, damit zum Beispiel durch Erschütterungen
verursachte Lageänderungen vermieden sind, bzw. stets eine
exakte Ausrichtung der Kontaktstifte gegeben ist, die Bodenplatte verdrehfest in dem Bauelement geführt sein.

Die gemäß der Erfindung ausgebildete Vorrichtung zur Halterung
von Bauelementen auf einer Leiterplatte ist nicht nur sehr
einfach in der konstruktiven Ausgestaltung und damit auf
wirtschaftliche Weise herzustellen, sondern durch diese Vorrichtung wird es vor allem ermöglicht, eine lötlose Kontaktierung vorzunehmen. Wird nämlich das auf einer Leiterplatte
anzuordnende Bauelement mit einer mit Kontaktstiften versehenen Bodenplatte ausgestattet, die mit der Leiterplatte
verspannbar ist, ist es möglich, die Kontaktstifte gegen die
auf der Leiterplatte aufkaschierten Leiterbahnen zu drücken,
so daß auf diese Weise die elektrische Verbindung zwischen
dem Bauelement und der Leiterplatte geschaffen wird und somit keine Lötungen erforderlich sind. Damit entfallen sowohl
die in eine Leiterplatte einzuarbeitenden Bohrungen für die
Kontakte als auch sämtliche mit einer Lötung verbundenen zusätzlichen Arbeiten. Das Bauelement ist vielmehr lediglich auf eine Leiterplatte aufzurasten, um eine zuverlässige, langlebige elektrische Verbindung herzustellen.

Selbst wenn an einer Leiterplatte gelötet werden muß, um zum Beispiel elektronische Bauteile zu befestigen, kann die Leiterplatte, bevor diese mit den elektrischen Bauelementen bestückt wird, sorgfältig gewaschen werden, ohne daß die Gefahr einer Beschädigung für die nachträglich ohne Schwierigkeiten aufzurastenden Bauelemente besteht.

Die erfindungsgemäße Haltevorrichtung ermöglicht es demnach, eine dynamische Kontaktierung vorzunehmen, die äußerst zuverlässig ist, aber dennoch nur einen geringen Arbeits- und Materialaufwand, zumal auch keine verzinnten Leiterplatten mehr notwendig sind, erfordert. Außerdem ist eine gleichmäßige Anpreßkraft und damit eine gute Anlage aller Kontakte gewährleistet, so daß eine Störanfälligkeit nicht zu befürchten ist.

Weitere Einzelheiten der Vorrichtung zur Halterung von Bauelementen auf einer Leiterplatte sind den in der Zeichnung dargestellten Ausführungsbeispielen, die nachfolgend im einzelnen erläutert sind, zu entnehmen. Hierbei zeigt

Fig. 1      ein an einer Leiterplatte mittels einer Haltevorrichtung abgestütztes elektrisches Bauelement in einem axialen Schnitt,

Fig. 2      einen Schnitt nach der Linie II-II der Fig. 1 ohne Andruckfeder      und

Fig. 3      eine andersartige Ausgestaltung der Haltevorrichtung nach Fig. 1

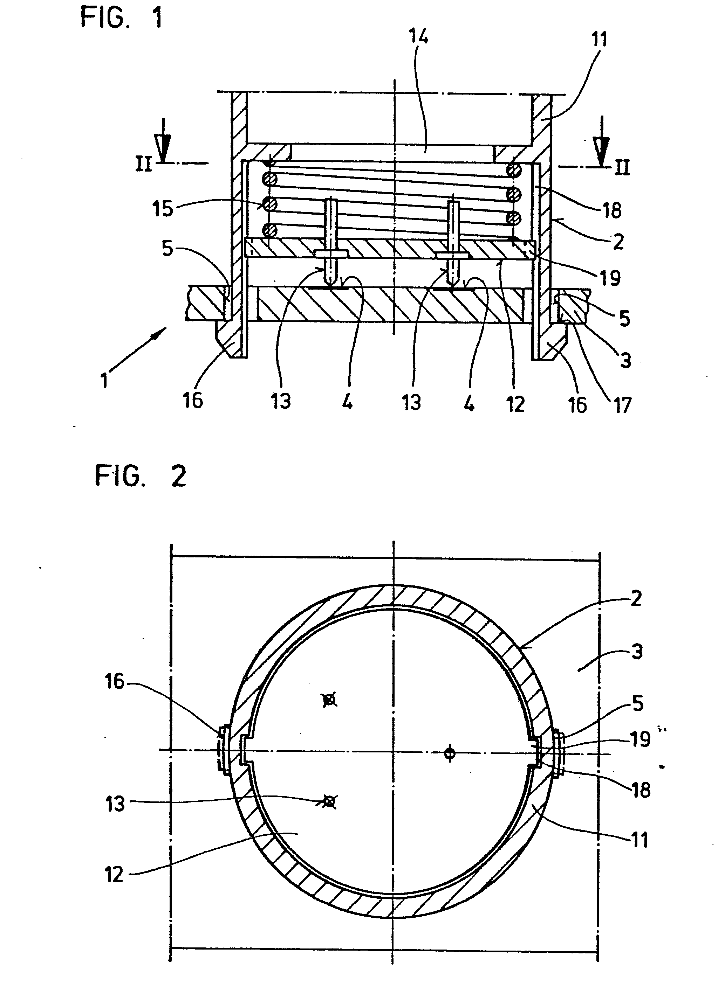

Die in Fig. 1 mit 1 bezeichnete Vorrichtung zur Halterung eines elektrischen Bauelementes 2 auf einer mit Leiterbahnen 4 versehenen Leiterplatte 3 besteht aus einer in dem Gehäuse 11 des Bauelementes 2 verschiebbar eingesetzten Bodenplatte 12, die mit drei Kontaktstiften 13 bestückt und mit der Leiterplatte 3 verspannbar ist. Dazu ist das Gehäuse 11 mit einer Zwischenwand 14 ausgestattet und zwischen dieser und der Bodenplatte 12 ist eine Druckfeder 15 angeordnet, durch die die Kontaktstifte 13 gegen die Leiterbahnen 4 gedrückt werden, da das Gehäuse 11 an der Leiterplatte 3 mittels diese durchgreifender Rastansätze 16 abgestützt ist.

Die mit einer Hinterschneidung 17 versehenen Rastansätze 16 sind bei der Montage des Bauelemente 2 durch die in die Leiterplatte 3 eingearbeiteten Ausnehmungen 5 hindurchgesteckt, so daß die elektrische Verbindung zwischen den Leiterbahnen 4 und den Kontaktstiften 13 somit nicht nur in kurzer Zeit und ohne daß irgendwelche Lötarbeiten vorzunehmen wären herzustellen ist, sondern es ist durch die Kraft der Feder 15, die auch vorgespannt sein kann, gewährleistet, daß die Kontaktstifte 13, die eine Dreipunktauflage bilden, mit ausreichendem Anpreßdruck an den Leiterbahnen 4 anliegen. Damit beispielsweise durch Erschütterungen keine Lageänderung der Bodenplatte 12 eintritt, bzw. damit stets eine exakte Ausrichtung der Kontaktstifte 13 zu den Leiterbahnen 4 gegeben ist, ist die Bodenplatte 12 verdrehfest in dem Gehäuse 11 geführt. Dazu sind in dieses zwei diametral einander gegenüberliegende axial gerichtete Einschnitte 18 eingearbeitet und die Bodenplatte 12 weist ebenfalls zwei Ansätze 19 auf, die in die Einschnitte 18 eingreifen.

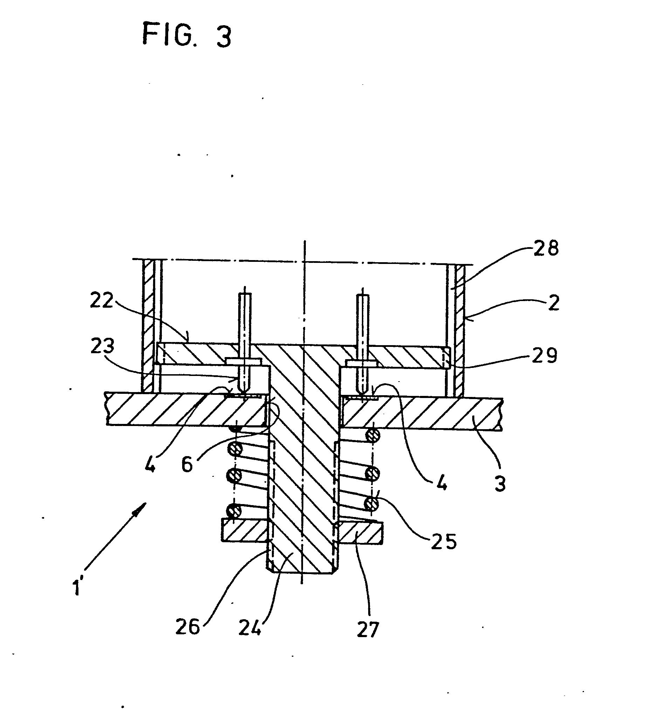

Bei der Haltevorrichtung 1' nach Fig. 3 ist eine in dem Bauelement 2 verschiebbar geführte Bodenplatte 22 unmittelbar mit der Leiterplatte 3 verspannt. Dazu ist an der

- 7 -

Bodenplatte 22 ein Ansatz 24 angebracht, der durch eine in die Leiterplatte 3 eingearbeitete Bohrung 6 hindurchgeführt ist und einen als Mutter 27 ausgebildeten Anschlagring aufweist. Zwischen der Leiterplatte 3 und der Mutter 27 ist eine Druckfeder 25 eingesetzt, durch die somit die Kontaktstifte 23 der Bodenplatte 22 gegen die Leiterbahnen 4 gedrückt werden.

Um die Verspannkraft einstellen zu können, ist die Mutter 27 auf ein in den Ansatz 25 eingearbeitetes Gewinde 26 aufgeschraubt. Außerdem ist die Bodenplatte 22 mittels in Einschnitte 28 des Bauteils 2 eingreifende Ansätze 29 ebenfalls unverdrehbar geführt.

Um eine ungleichmässige Anlage der Kontaktstifte 13 bzw. 23 auf den Leiterbahnen 4 auszuschließen, können die Kontaktstifte 13 bzw. 23 in Achsrichtung federnd angeordnet werden. Dies ist in der Weise zu bewerkstelligen, daß zwischen diesen und der Bodenplatte 12 bzw. 22 jeweils eine Druckfeder eingesetzt wird.

A 6605 e-s
11. August 1980

0047827

Rafi GmbH & Co
Elektrotechnische Spezialfabrik

7981 Berg b. Ravensburg

P a t e n t a n s p r ü c h e :

1. Vorrichtung zur Halterung elektrischer Bauelemente,
   wie Taster, Schalter oder dgl., auf einer Leiterplatte, die miteinander elektrisch leitend verbunden
   sind,

   d a d u r c h   g e k e n n z e i c h n e t ,

   daß das Bauelement (2) jeweils eine mit einem oder
   mehreren Kontaktstiften (13; 23) versehene Bodenplatte
   (12; 22) aufweist, die über das Bauelement (2) oder
   unmittelbar mit der Leiterplatte (3) verspannbar ist.

   ./.

2. Haltevorrichtung nach Anspruch 1,

   d a d u r c h   g e k e n n z e i c h n e t ,

   daß zur Verspannung der Bodenplatte (12) diese entgegen der Kraft einer oder mehrerer Federn (15) verschiebbar in dem Gehäuse (11) des Bauelementes (2)
   gehalten ist und daß die Bodenplatte (12) sowie das
   Gehäuse (11) des Bauelementes (2) an der Leiterplatte
   (3) abgestützt sind.

3. Haltevorrichtung nach Anspruch 1 oder 2,

   d a d u r c h   g e k e n n z e i c h n e t ,

   daß die auf die Bodenplatte (12) einwirkende Feder
   (15) an einer Zwischenwand (14) des Gehäuses (11)
   abgestützt ist.

4. Haltevorrichtung nach einem der Ansprüche 1 bis 3,

   d a d u r c h   g e k e n n z e i c h n e t ,

   daß zur Abstützung des Gehäuses (11) an der Leiterplatte (3) an diesem mit Hinterschneidungen (17)
   versehene Rastansätze (16) angeformt sind, die
   Ausnehmungen (5) der Leiterplatte (3) durchgreifen.

5. Haltevorrichtung nach Anspruch 1,

   d a d u r c h   g e k e n n z e i c h n e t ,

daß zur unmittelbaren Verspannung der Leiterplatte (3)
mit einer Bodenplatte (22) diese einen die Leiterplatte
(3) durchgreifenden Ansatz (24) aufweist, zwischen dem
und der Leiterplatte (3) eine Druckfeder (25) abgestützt
ist.

6. Haltevorrichtung nach Anspruch 5,

   d a d u r c h   g e k e n n z e i c h n e t ,

   daß zur Einstellung der Verspannkraft der Ansatz (25) mit
   einem verstellbaren, beispielsweise durch eine auf diesen
   aufschraubbare Mutter (27) gebildeten Anschlag, versehen ist.

7. Haltevorrichtung nach einem der Ansprücke 1 bis 6,

   d a d u r c h   g e k e n n z e i c h n e t ,

   daß die Bodenplatte (12; 22) jeweils über eine aus Auflagenocken und/oder Kontaktstiften (13; 23) gebildete Dreipunkt-
   Abstützung auf der Leiterplatte (3) gehalten ist.

8. Haltevorrichtung nach einem der Ansprüche 1 bis 7,

   d a d u r c h   g e k e n n z e i c h n e t ,

   daß die Kontaktstifte (13; 23) in Achsrichtung federnd gehalten sind.

9. Haltevorrichtung nach einem der Ansprüche 1 bis 8,

   d a d u r c h   g e k e n n z e i c h n e t ,

   daß die Bodenplatte (12; 22) verdrehfest in dem Bauelement
   (2) geführt ist.

8. August 1980 e-1
A 6605

FIG. 1

FIG. 2

# FIG. 3

| | | 0047827 |
|---|---|---|
| **Europäisches Patentamt** | **EUROPÄISCHER RECHERCHENBERICHT** | Nummer der Anmeldung<br>EP 81 10 5369 |

## EINSCHLÄGIGE DOKUMENTE

| Kategorie | Kennzeichnung des Dokuments mit Angabe, soweit erforderlich, der maßgeblichen Teile | betrifft Anspruch | KLASSIFIKATION DER ANMELDUNG (Int Cl 3) |
|---|---|---|---|
| | IBM TECHNICAL DISCLOSURE BULLETIN, vol. 10, no. 10 März 1968, New York, US<br>R.T. EVANS "Constant pressure pluggable circuit elements" Seiten 1521-1522.<br><br>* Seiten 1521-1522 *<br><br>-- | 1,3 | H 01 R 23/72 |
| | FR - A - 1 394 490 (PHILIPS)<br>* Seite 1, rechte Spalte - Seite 2, linke Spalte *<br><br>-- | 1,5,6, 8 | |
| | FR - A - 1 454 867 (GENERAL MOTORS)<br>* Seite 1, rechte Spalte, Absatz 9 - Seite 2, linke Spalte, Absätze 1,3-5 *<br><br>-- | 1,5-8 | RECHERCHIERTE SACHGEBIETE (Int. Cl.3)<br><br>H 01 R 23/72<br>H 01 R 9/09<br>H 05 K 1/08<br>1/12<br>1/18<br>H 05 K 7/00<br>7/02<br>7/10<br>7/12 |
| | DE - A - 2 651 336 (SIEMENS)<br>* Figuren; Seite 9, Absatz 3 - Seite 11, Absatz 1 *<br><br>-- | 1,5,8, 9 | |
| | DE - A - 2 348 165 (SIEMENS)<br>* Seite 10, Absatz 2 - Seite 11, Absatz 2; Figuren *<br><br>-- | 1,4,5, 8,9 | KATEGORIE DER GENANNTEN DOKUMENTE |
| A | FR - A - 1 423 909 (SOCAPEX)<br>* Figuren *<br><br>---- | 4,8 | X: von besonderer Bedeutung allein betrachtet<br>Y: von besonderer Bedeutung in Verbindung mit einer anderen Veröffentlichung derselben Kategorie<br>A: technologischer Hintergrund<br>O: nichtschriftliche Offenbarung<br>P: Zwischenliteratur<br>T: der Erfindung zugrunde liegende Theorien oder Grundsätze<br>E: älteres Patentdokument, das jedoch erst am oder nach dem Anmeldedatum veröffentlicht worden ist<br>D: in der Anmeldung angeführtes Dokument<br>L: aus andern Gründen angeführtes Dokument |
| | Der vorliegende Recherchenbericht wurde für alle Patentansprüche erstellt. | | &: Mitglied der gleichen Patentfamilie, übereinstimmendes Dokument |

| Recherchenort | Abschlußdatum der Recherche | Prüfer |
|---|---|---|
| Den Haag | 23-12-1981 | RAMBOER |

EPA form 1503.1 06.78